# EUROPEAN PATENT APPLICATION

(11) **EP 2 944 400 A1**
(43) Date of publication of application: **18.11.2015**
(21) Application number: 13870796.3
(22) Date of filing: 11.01.2013
(51) Int. Cl.: B22F 1/00, C22F 1/00, H01L 21/60

(54) **Cu BALL**

(71) Applicant: Senju Metal Industry Co., Ltd, Tokyo 120-8555 (JP)
(72) Inventor: HATTORI Takahiro, Tokyo 120-8555 (JP); KAWASAKI Hiroyoshi, Tokyo 120-8555 (JP); ROPPONGI Takahiro, Tokyo 120-8555 (JP); SOMA Daisuke, Tokyo 120-8555 (JP); SATO Isamu, Tokyo 120-8555 (JP)
(74) Representative: D Young & Co LLP
(86) International application number: PCT/JP2013/050424
(87) International publication number: WO 2014/109052

(57) **Abstract**

To provide Cu ball that has an excellent alignment performance.

In order to control wettability failure of the Cu ball at a moment of soldering, lightness is regulated as an index of determining oxide film thickness on a surface of the ball and the lightness is set to be 55 or more. Further, since it is preferable that the Cu ball has a higher sphericity to measure the lightness accurately, the purity of the Cu ball is set to be 99.995% or less to order to make the sphericity higher. When the lightness is 55 or more, it is preferable that the thickness of oxide film formed on the surface of the Cu ball is 8 nm or less.

## Description

### [TECHNICAL FIELD]

The present invention relates to Cu ball to be used in the soldering of electronic components or the like.

### [BACKGROUND]

Development of small information equipment has been rapidly advanced miniaturization of its electronic components mounted thereon in recent years. Ball grid allay (hereinafter, referred to as "BGA") has been applied to the electronic components so that electrodes are arranged on a rear surface thereof, in order to cope with narrowing of the terminals and/or reduced size of mounting area according to downsizing requirement.

As the electronic component to which BGA is applied, a semiconductor package is exemplified. In the semiconductor package, a semiconductor chip having electrodes is sealed by any resins. On the electrodes of the semiconductor chip, solder bumps are formed. Each solder bump is formed by connecting a solder ball with the electrode of the semiconductor chip. The semiconductor package to which BGA is applied is mounted on a printed circuit board by putting each solder bump on the printed circuit board so that each solder bump can contact an electrically conductive land of the printed circuit board and connecting the solder bump fused by heating with the land. Further, in order to cope with any higher density mounting requirement, a three dimensional high density mounting structure in which the semiconductor packages are piled along a height direction thereof has been studied.

However, when BGA is applied to the semiconductor packages on which the three dimensional high density mounting is performed, each solder ball becomes flat by weight of the semiconductor packages, which causes a short-circuit between the electrodes. This constitutes any hindrance to the high density mounting performance.

Accordingly, a solder bump in which Cu ball is connected to an electrode of an electronic component through solder paste has been studied. The solder bump having the Cu ball can support the semiconductor package by the Cu ball which does not melt at a melting point of the solder alloy when mounting the electronic component on the printed circuit board even if the weight of the semiconductor packages is applied to the solder bump. Therefore, it is impossible for the solder bump to become flat by the weight of the semiconductor packages. As a related art, for example, patent document 1 is exemplified.

### [DOCUMENT FOR PRIOR ART]

### [PATENT DOCUMENT]

Patent Document 1: International Publication No.95/24113

### [SUMMARY OF THE INVENTION]

### [PROBLEM TO BE SOLVED BY THE INVENTION].

However, although the Cu ball disclosed in the patent document 1 has been required for a high purity in order to manufacture it by fusing Cu pieces under a non-oxidizing atmosphere to enhance sphericity thereof, an alignment performance thereof indicating a registration tolerance has not been studied at all.

When the electronic components to which BGA is applied using Cu balls are mounted on the printed circuit board, they are treated as connection failure if the Cu ball falls down from the electrode. Further, when the Cu ball is connected to the electrode with it being deviated from a predetermined position, the electrodes including the Cu bump have any uneven heights. The electrode having higher height can connect a land but the electrode having lower height cannot connect the land. The electronic components in which the Cu balls are connected to be deviated from the predetermined position are also treated as connection failure. Therefore, the Cu ball has been required to have a higher level alignment performance.

This invention has a problem to provide Cu ball that has an excellent alignment performance.

### [MEANS FOR SOLVING THE PROBLEMS]

The inventors have focused on a jointing aspect of the Cu ball in order to enhance the alignment performance of the Cu ball. Specifically, they have focused on that a surface condition of the Cu ball has an influence on its wettability to solder powder in the solder paste, taking into consideration that the Cu ball is electrically connected to the electrode through the solder powder in the solder paste. Additionally, because the Cu ball has a characteristic that is susceptible of oxidation, the thinner the oxide film on a surface of the Cu ball is, the higher its wettability to solder powder in the solder paste is. The inventors have obtained knowledge such that it has an excellent alignment performance.

Here, when the Cu ball is regulated by only oxygen concentration and oxide film thickness in order to enhance the alignment performance of the Cu ball, it is necessary to measure them on all of the manufactured Cu balls, so that expensive equipment and/or long measurement period are required. Therefore, the regulation by only oxygen concentration and oxide film thickness is not realistic. Even if the sample chosen to measure oxygen concentration and oxide film thickness, it may not be correct that the Cu ball on which they are not measured has an excellent alignment performance.

Accordingly, the inventors have studied the enhancement of the alignment performance thereof by regulating condition of oxide film of the Cu ball using any index.

When the Cu ball has an oxide film thickness of about 70 through 100 nm, it colors ocher. It seems to enhance the alignment performance by regulating condition of oxide film of the Cu ball by yellowness. However, such a thick oxide film is formed gradually while the Cu ball is left for a long time under a high-temperature and high-humidity environment. The Cu ball stored at about 20 through 40 degrees C does not form such a thick oxide film even if it is left under a high-humidity environment. Therefore, it is hard to think about the enhancement of the alignment performance even by regulating the Cu ball using yellowness. The inventors have examined these points and have obtained knowledge such that it is difficult to regulate the Cu ball by yellowness, which is similar to a case of the solder ball.

The Cu ball stored at a temperature of about 20 through 40 degrees C has an oxide film thickness of about 40nm or less. In this moment, the Cu ball colors brawn. It seems to enhance the alignment performance by regulating condition of oxide film of the Cu ball using redness. However, Cu is reddish from the first so that even if the Cu ball colors brown by its oxide film, it seems to be impossible to determine degree of oxidation in the Cu ball with a high precision. The inventors also have examined the point and have obtained knowledge such that it is impossible to enhance the alignment performance of the Cu ball by regulating condition of oxide film of the Cu ball by redness.

Accordingly, the inventors have focused on that when the Cu ball is oxidized, its metallic luster loses and they have obtained knowledge such that wettability failure of the Cu ball is controlled to dramatically enhance the alignment performance by regulating condition of oxide film of the Cu ball using lightness as the index regulating degree of oxidation in the Cu ball. The inventors have also unexpectedly obtained knowledge such that the sphericity of the Cu ball is increased when the purity thereof is 99.995% or less, taking into consideration that the Cu ball is required to have a higher sphericity in order to measure the lightness more accurately, and have completed this invention.

Here, this invention thus completed on the basis of this knowledge will describe as follows:
(1) A Cu ball characterized in that the ball contains a purity of 99.995% or less and lightness of 55 or more.
(2) The Cu ball described in the above-mentioned item (1) further containing oxide film thickness of 8 nm or less on its surface.
(3) The Cu ball described in the above-mentioned item (1) or (2), further containing sphericity of 0.95 or more.
(4) The Cu ball described in any one of the above-mentioned items (1) through (3), wherein the Cu ball contains a diameter of 1 through 1000 µm.
(5) A solder joint using the Cu ball according to any one of the above-mentioned items (1) through (4).

### [BRIEF DESCRIPTION OF DRAWINGS]

[FIG.1] FIG. 1 is a SEM photograph of Cu balls which are manufactured using Cu pellet having a purity of 99.9 %.
[FIG.2] FIG. 2 is a SEM photograph of Cu balls which are manufactured using Cu wire having a purity of 99.995% or less.
[FIG. 3] FIG. 3 is a SEM photograph of Cu balls which are manufactured using Cu plate having a purity exceeding 99.995%.
[FIG.4] FIG.4 is an optical microscope photograph of a solder bump mounting Cu ball according to the invention.
[FIG.5] FIG.5 is an optical microscope photograph of a solder bump mounting Cu ball according to a comparison example.
[FIG.6] FIG.6 is a graph showing a relationship between L* value and oxide film thickness.
[FIG.7] FIG.7 is a graph showing a relationship between b* value and oxide film thickness.
[FIG.8] FIG.8 is a graph showing a relationship between a* value and oxide film thickness of Cu ball.
[FIG.9] FIG.9 is a graph showing a relationship between L* value and average movement from mounting center position of the Cu balls after the Cu balls are mounted on the electrodes.

### [MODE FOR IMPLEMENTING THE INVENTION]

The following will describe this invention more in detail. In this description, units (such as ppm, ppb and %) relating to composition of the Cu ball represent ratios to mass of the Cu ball (for example, mass ppm, mass ppb and mass %) unless otherwise specified.

### Lightness: 55 or more

The Cu ball according to the invention has lightness of 55 or more. Here, the lightness is referred to as L* value of L*a*b* color space (hereinafter, also referred to merely as "L* value". When the lightness is 55 or more, the oxide film of the Cu ball is thin so that the alignment performance is enhanced. When photographing an image by a CCD camera or the like to confirm any failure on the solder ball and any movement from mounting center position, accuracy of these confirmations is also enhanced. Further, when measuring uneven heights of the solder bumps by a laser wave meter, accuracy of the measurement of uneven heights thereof is also improved. As a result thereof, inspection accuracy of the electronic components is improved, so that product yield of the electronic components is improved.

When the lightness is less than 55, a thick oxide film mainly composed of Cu₂O is formed on a surface of the Cu ball. This causes wettability failure to solder powder in the solder paste to occur, which deteriorates alignment performance. When the thick oxide film is formed, the Cu ball loses metallic luster, so that inspection accuracy of the electronic components deteriorates. Further, the formation of thick oxide film causes electrical conductivity and/or thermal conductivity of the Cu ball to deteriorate.

In order to further enhance effect of the Cu ball according to the invention, the lightness is preferably 57 or more, more preferably 59 or more. Upper limit of the lightness is preferably 70 or less because the lightness by the metallic luster Cu inherently has is the upper limit thereof.

### Purity of Cu Ball: 99.995% or less

The Cu ball according to this invention has a purity of 99.995% or less. In other words, the Cu ball according to this invention has content of elements excluding Cu (hereinafter, suitably referred to as "impurity elements") of 50 ppm or more. When the purity of Cu constituting the Cu ball stays within this range, it is possible to maintain a sufficient amount of crystal core in the fused Cu so that the sphericity of the Cu ball is increased. Further, when the sphericity is increased, measurement error of the lightness is decreased. The reason why the sphericity of the Cu ball is increased when the purity of the Cu ball is low will be described more in detail as follows.

When manufacturing the Cu ball, chips of Cu material each being formed so as to have a predetermined shape are fused by heating them and then, the fused Cu is made spherical by its surface tension. This is then solidified so as to be the Cu ball. During a process from a liquid state of the fused Cu to the solidifying state thereof, the crystal grain grows in the spherical fused Cu. In this moment, when there are many impurity elements, these impurity elements become crystal cores and they inhibit the crystal grain from growing. Therefore, the spherical fused Cu becomes a Cu ball having high sphericity by growth-inhibited and refined crystal grains. On the other hand, when there are few impurity elements, the crystal grain grows with an orientation without inhibiting the crystal grain from growing because there are relatively few crystal cores. As a result thereof, the spherical fused Cu is solidified with a part of the surface thereof being projected. Such a Cu ball has less sphericity. As the impurity elements, Sn, Sb, Bi, Zn, As, Ag, Cd, Ni, Pb, Au, P, S, U, Th and the like are conceivable.

Although a lower limit of the purity is not specifically fixed, it is preferably 99.9%, from a viewpoint of preventing deterioration of electroconductivity and/or thermal conductivity of the Cu ball because of less purity thereof. Namely, the content of the impurity elements in the Cu ball excluding Cu is preferably 1000 ppm or less in total.

As described above, the elements, Sn, Sb, Bi, Zn, As, Ag, Cd, Ni, Pb, Au, P, S, U, Th and the like are conceivable as the impurity elements. It is preferable that the Cu ball according to this invention particularly contains Pb and Bi as the impurity elements among the impurity elements. It is preferable that their content is 1 ppm or more in total. Normally, the content of Pb and/or Bi in Cu member is 1 ppm or more in total. In the manufacture of the Cu ball, Cu is not heated at temperature above the melting points of Pb and Bi. In other words, the content of Pb and Bi is not largely decreased. Thus, since some amounts of Pb and Bi remain after the manufacture of the Cu ball, there is a few measurement error of their content. Therefore, the elements, Pb and Bi are important elements for estimating content of the impurity elements. From this viewpoint, it is preferable that the content of Pb and Bi is 1 ppm or more in total. It is more preferable that the content of Pb and/or Bi is 10 ppm or more in total. Although an upper limit thereof is not specifically fixed, it is more preferable that the Pb and Bi contents are less than 1000 ppm in total, from a viewpoint of preventing the electroconductivity of the Cu ball from being deteriorated.

### Oxide Film Thickness: 8 nm or less

It is preferable that the oxide film thickness of the Cu ball according to the invention is 8 nm or less. When the film thickness is 8 nm or less, the oxide film is thin so that the wettability failure is prevented to enhance the alignment performance. The solder paste through which the Cu ball is connected to the electrode normally contains flux. The flux dissolves and removes thin oxide film of 8 nm or less by rosin which is principal ingredient thereof. Therefore, since the Cu ball according to the invention prevents the wettability failure, its (self) alignment performance is excellent. Namely, even if the Cu ball is slightly shifted from a center of the electrode just after it is mounted, the Cu ball moves to the center of the electrode when the soften solder paste is made uniform on whole surface of the electrode by its surface tension in a moment of the reflow soldering. Further, when the film thickness is 8 nm or less, the electrical conductivity and thermal conductivity of the Cu ball is enhanced.

In order to more enhance such an effect, the oxide film thickness is preferably 7 nm or less, more preferably 6 nm or less. Although a lower limit of the oxide film thickness is not specifically fixed, the thinner it is, the more the wettability failure can be decreased.

### Sphericity of Cu Ball: 0.95 or more

Regarding a configuration of the Cu ball according to this invention, it is preferable that the sphericity thereof is higher from a viewpoint that the measurement error of lightness is decreased. When the sphericity is higher, it is also possible to decrease the stand-off height error. When the sphericity of the Cu ball is less than 0.95, the Cu ball has an indeterminate configuration. The bumps having uneven heights are formed when forming the bumps, so that there may be a strong possibility that any connection failure occurs. It is more preferable that the sphericity is 0.990 or more. In this invention, a deviation from a complete sphericity of the ball is referred to as the "sphericity". In this invention, a deviation from a complete sphericity of the ball is referred to as the "sphericity". The sphericity is obtained by various kinds of methods such as a least square center (LSC) method, a minimum zone center (MZC) method, a maximum inscribed circle (MIC) method, a minimum circumscribing circle (MCC) method and the like.

### Diameter of Cu Ball: 1 through 1000 µm

It is preferable that the Cu ball according to this invention has a diameter of 1 through 1000 µm. When it is within this range, it is possible to manufacture the spherical Cu ball stably and inhibit the terminals from being short-circuited when these terminals are narrow pitch terminals. When the diameter of the Cu ball is 1 µm or more, it is possible to manufacture the spherical Cu ball stably. Further, the diameter of the Cu ball is 1000 µm or less, it is possible to inhibit the terminals from being short-circuited when these terminals are narrow pitch terminals. Here, for example, when the Cu ball according to this invention is used as Cu in Cu paste, the Cu ball may be referred as to "Cu powder". When the Cu ball is referred as to the Cu powder, the Cu ball generally has a diameter of 1 through 300 µm.

The following will describe an example of a method of manufacturing the Cu ball according to this invention.

The Cu material as material is put on a plate having heat-resisting property (hereinafter, referred to as "heat-resisting plate") such as ceramics and is heated in a furnace together with the heat-resisting plate. There are many dimples each having a hemispheric bottom in the heat-resisting plate. A diameter of the dimple and a depth thereof are suitably set according to a diameter of the Cu ball. For example, the diameter thereof is 0.8 mm and the depth thereof is 0.88 mm. Further, the Cu materials each having a chip shape (hereinafter, referred to as "chip material"), which are obtained by cutting a fine wire made of Cu, are put into the dimples one by one in the heat-resisting plate. The heat-resisting plate in which the chip material have been put into each of the dimples is heated at about 1000 degrees C in the furnace into which ammonia decomposition gas is filled and heating process is performed thereon during 30 through 60 minutes. In this moment, when temperature in the furnace is more than the melting point of Cu, the chip material is fused so that it becomes sphered. Thereafter, the interior of the furnace is cooled and the Cu ball is formed in each of the dimples of the heat-resisting plate.

Further, as other methods, there are an atomizing method in which the fused Cu is dropped down from an orifice pierced in a bottom of a melting pot and the droplet is cooled to be granulated as the Cu ball and a granulation method in which thermal plasma heats cut metal of Cu at a temperature of 1000 degrees C or more.

As the Cu material that is a raw material of the Cu ball, for example, pellet, wire, pillar or the like can be used. The Cu material may have a purity of 99 through 99.995% from a viewpoint such that the purity of the Cu ball does not too decrease.

### Storing Method of Cu Ball:

The Cu ball according to the invention may react with oxygen in an atmosphere based on temperature and humidity of storage environment to form an oxide film on a surface thereof. Thus, it is preferable that the just manufactured Cu ball is stored at normal temperature and normal humidity in a case of storing it in the atmosphere. In this invention, the normal temperature and the normal humidity are respectively 5 through 35 degrees C and 45 through 85 %, according to JIS Z 8703. Further, when reducing the oxidation of Cu ball as much as possible, it is particularly preferable to store the Cu ball under inert gas such as He, Ar and the like, nitrogen gas or an environment like a clean room.

Additionally, the purity regulated in this invention can be applied to Cu column and Cu pillar.

Furthermore, the Cu ball according to the invention is electrically connected to the electrode by the solder paste so that it can be used in a solder joint for an electronic component.

The Cu ball according to this invention has low α dose by using low α-ray material. Such Cu ball having low α dose can suppress any software errors when it is used as solder bump around a memory. In order to manufacture the Cu ball having low α dose, Cu material is heated at about 800 through 1000 degrees C for 30 through 60 minutes and a melting temperature of Cu is increased to about 1100 through 1300 degrees C in a moment of manufacturing it by a conventional atomizing method. Further, separately, the manufactured Cu ball may be again heated at 800 through 900 degrees C that is less than the melting point of Cu. This causes radioactive isotope such as ²¹⁰Po to evaporate, so that α dose is decreased.

### [EMBODIMENTS]

The following will describe embodiments of the invention, but the invention is not limited thereto. In the embodiments, it was presumed to store the Cu balls under various kinds of conditions in order to examine a relation among L* value, oxide film thickness and alignment performance. The following studies were performed using various kinds of Cu balls having different L* values.

First, in order to measure the lightness accurately, manufacturing conditions of the Cu ball having the high sphericity were examined. Cu pellet having a purity of 99.9 %, Cu wire having a purity of 99.995 % or less and Cu plate having a purity exceeding 99.995 % were prepared. They were respectively put into melting pots and then, the melting pots were then heated up to a temperature of 1200 degrees C and this heating process was performed thereon during 45 minutes. The fused Cu was dropped down from an orifice pierced in the bottom of each of the melting pots. The droplets were cooled so as to be granulated as the Cu balls. Thus, the Cu balls each having a mean diameter of 250 µm were manufactured. A table 1 shows a result of an elementary analysis and sphericity of the manufactured Cu balls. The following will describe a method of measuring the sphericity more in detail.

### Sphericity:

The sphericity was measured by CNC image measurement system. Equipment therefor was ultra quick vision, ULTRA QV350-PRO manufactured by MITSUTOYO Corporation.

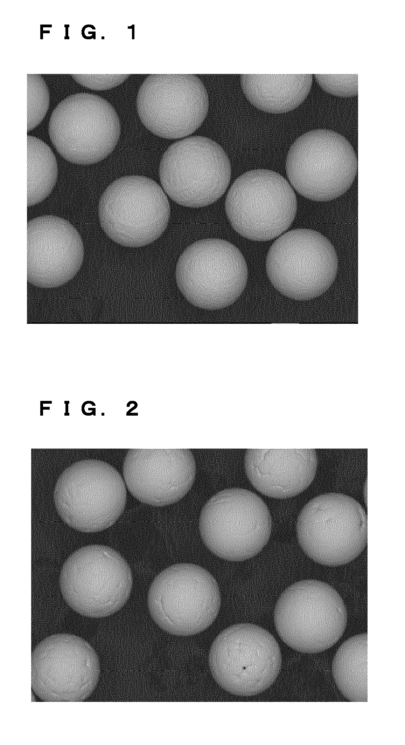

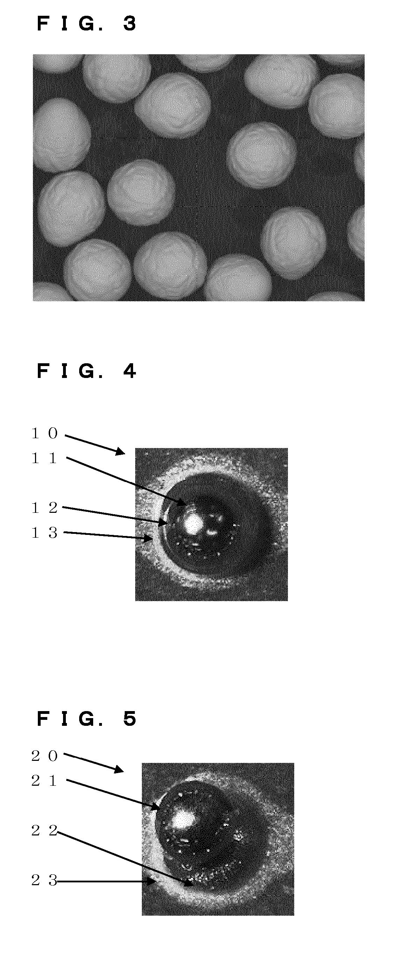

Further, SEM photographs of the respective manufactured Cu balls are shown in FIGS. 1 through 3. FIG. 1 is a SEM photograph of the Cu balls which are manufactured using Cu pellet having a purity of 99.9 %. FIG. 2 is a SEM photograph of Cu balls which are manufactured using Cu wire having a purity of 99.995% or less. FIG. 3 is a SEM photograph of Cu balls which are manufactured using Cu plate having a purity exceeding 99.995%. The magnification of the SEM photograph in 100 times.

**[Table 1]**

| | ALLOY COMPOSITION | | | | | | | | | | | | | | | SPHERICITY |
|---|---|---|---|---|---|---|---|---|---|---|---|---|---|---|---|---|
| | Cu | Sn | Sb | Bi | Zn | As | Ag | Cd | Ni | Pb | Au | P | S | U | Th | |
| Cu BALL USING Cu PELLET HAVING PURITY OF 99. 9% | bal. | 84 | 21 | 32 | 3 | 49 | 20 | 7 | 4 | 16 | 4 | 200 | 18 | 1.5 | <0.5 | 0.9932 |
| Cu BALL USING Cu WIRE HAVING PURITY OF 99. 995% | bal. | 8 | 10 | 19 | - | 24 | 13 | - | 1 | 8 | - | - | - | <0.5 | <0.5 | 0.9931 |
| Cu BALL USING Cu PLATE HAVING PURITY EXCEEDING 99. 995% | bal. | 13 | 2 | 18 | - | 10 | - | - | - | 3 | - | - | - | 0.9 | <0.5 | 0.9227 |

| | | | | | | | | | | | | | | | | |
|---|---|---|---|---|---|---|---|---|---|---|---|---|---|---|---|---|
| *U and Th are shown by mass ppb. Remaing elements are shown by mass ppm. | | | | | | | | | | | | | | | | |

As shown in the Table 1, FIGS. 1 and 2, both of the Cu balls using the Cu pellet having a purity of 99.9 % and the Cu wire having purity of 99.995% or less show sphericity of 0.990 or more. On the other hand, as shown in the Table 1 and FIG. 3, the Cu balls using the Cu plate having a purity exceeding 99.995% show sphericity of less than 0.95. Therefore, in all of the following embodiments and comparison examples, various kinds studies were performed using the Cu balls manufactured using the Cu pellet having a purity of 99.9 %.

### Embodiment 1

Regarding the Cu balls manufactured as described above, their lightness and oxide film thickness just after the manufacture thereof (less than one minute from the manufacture thereof) were measured under the following conditions. Respective Cu balls were then mounted on 30 electrodes on which the solder paste (M705-GRN360-K2-V; manufactured by Senju Metal Industry Corporation) had been printed by a metal mask with a thickness of 100 µm. The Cu balls were connected to the electrodes by reflow to make solder bumps. The reflow was performed at under the conditions of a peak temperature of 245 degrees C and N₂ atmosphere. It is to be noted that since oxygen concentration was 100 ppm or less, increase in the oxide film thickness by the reflow does not exert any influence on the measurement of lightness. Thereafter, the measurement of the lightness and the oxide film thickness, an assessment of the alignment performance and a measurement of average movement from mounting center position were performed on the manufactured solder bumps. The average movement from mounting center position is a value to assess the alignment performance objectively by presentation in numbers. The results are shown in Table 2. The following will describe each measurement and each assessment more in detail.

### Measurement of Lightness:

The lightness was obtained from color values (L*, a* and b*) by measuring spectral transmittance according to JIS Z 8722 (Color-Measuring Method; Colors of Reflective Object and Transmissible Object) with D65 light source and a field of vision of 10 degrees using spectrophotometer CM-3500d manufactured by Minolta. It is to be noted that the color values (L*, a* and b*) is regulated in JIS Z 8729 (Color-Representing Method; (L* a*b* Color Space and L*u*v* Color Space).

### Measurement of Oxide Film Thickness:

The oxide film thickness of the Cu ball was measured by the following equipment and conditions. The measurement value of the oxide film thickness was obtained in SiO₂ equivalent.
Measurement Equipment: Scanning FE Auger electron spectroscopic analyzer, manufactured by ULVAC-PHI, INC.
Measurement Condition: Beam voltage of 10 kV; Target current of 10 nA (The measurement method of spatter depth using Ar ion gun is based on ISO/TR 15969).

### Assessment of alignment performance:

All 30 electrodes on which the solder bumps had been formed were photographed by an optical microscope by 40 times. FIG.4 is an optical microscope photograph of a solder bump 10 mounting the Cu ball 11 according to the invention. FIG.5 is an optical microscope photograph of a solder bump 20 mounting Cu ball 21 according to a comparison example. These photographs are photographs which photograph situations in which the Cu balls 11, 21 are mounted on the electrodes 13, 23 on which the solder pastes 12, 22 had been printed, from a side of each of the Cu balls 11, 21. The magnification of the photograph is 40 times.

As shown in FIG. 4, the Cu ball 11 according to the invention is mounted on a center of the electrode 13, which indicates that any movement from mounting center position does not occur. On the other hand, as shown in FIG. 5, the Cu ball 21 according to the comparison example juts out of the electrode 23, which indicates that movement from mounting center position occurs. In this embodiment, the Cu ball 21 that jutted a little out of the electrode 23 was treated as the Cu ball in which movement from mounting center position occurs. The alignment performance was assessed by numbers of the Cu balls in which movement from mounting center position occurs.
Circular mark: No movement from mounting center position occur in all 30 electrodes; and
Cross mark: Movement from mounting center position occurs in at least one electrode.

### Measurement of Average Movement from Mounting Center Position:

A distance between the center of the electrode and the center of reflowed Cu ball bump was measured on 30 solder bumps by measurement of circle center-to-circle center distance using VH-S30 manufactured by KEYENCE. An average of the 30 measured results is the average movement from mounting center position. In this embodiment, it is estimated that if the average movement from mounting center position is 30 µm or less, the Cu ball has an excellent alignment performance at the moment of mounting.

### Embodiments 2 through 6 and Comparison Examples 1 through 4:

In the embodiments 2 through 6 and the comparison examples 1 through 4, the Cu balls which had been stored under a storage conditions shown in a Table 2 were assessed like the embodiment 1. The results thereof are shown in the Table 2.

It is to be noted that in the Table 2, the terms, "Room Temperature" indicate 20 degrees C. Further, humidities when the measurement at "Room Temperature" and 200 degrees C are both 50%.

**[Table 2]**

| | STORAGE CONDITION | STORAGE PRERIOD | L*VALUE | OXIDE FILM THICKNESS [nm] | ALIGNMENT PERFORMANCE | POSITION GAP AVERAGE [*µ*m] |
|---|---|---|---|---|---|---|
| EMBODIMENT 1 | ROOM TEMPERATURE | LESS THAN 1 MINUTE | 63.58 | 2.5 | ○ | 14.3 |
| EMBODIMENT 2 | ROOM TEMPERATURE | 2 DAYS | 61.53 | 3.3 | ○ | 18.4 |
| EMBODIMENT 3 | ROOM TEMPERATURE | 7 DAYS | 64.22 | 4.0 | ○ | 21.5 |
| EMBODIMENT 4 | ROOM TEMPERATURE | 14 DAYS | 63.06 | 4.7 | ○ | 14.4 |
| EMBODIMENT 5 | TEMPERATUARE: 200°C | 1 MINUTE | 63.50 | 3.7 | ○ | 25.6 |
| EMBODIMENT 6 | TEMPERATUARE: 200°C | 5 MINUTES | 59.77 | 5.9 | ○ | 29.0 |
| COMPARISON EXAMPLE 1 | TEMPERATUARE: 40°C | 2 DAYS | 51.22 | 9.1 | × | 42.7 |
| | HUMIDITY: 90% | | | | | |
| COMPARISON EXAMPLE 2 | TEMPERATUARE: 40°C | 7 DAYS | 50.91 | 12.3 | × | 45.8 |
| | HUMIDITY: 90% | | | | | |
| COMPARISON EXAMPLE 3 | TEMPERATUARE: 40°C | 14 DAYS | 47.93 | 13.1 | × | 48.4 |
| | HUMIDITY: 90% | | | | | |
| COMPARISON EXAMPLE 4 | TEMPERATUARE: 200°C | 10 MINUTES | 40.35 | 15.9 | × | 51.7 |

As shown in the Table 2. all of the embodiments 1 through 6 indicating L* value of 55 or more indicated circular marks in the alignment performance and their average movements from mounting center position were all 30 µm or less. On the other hand, the comparison examples 1 through 4 indicating L* value of less than 55 indicated cross marks in the alignment performance and their average movements from mounting center position exceeded all 40 µm.

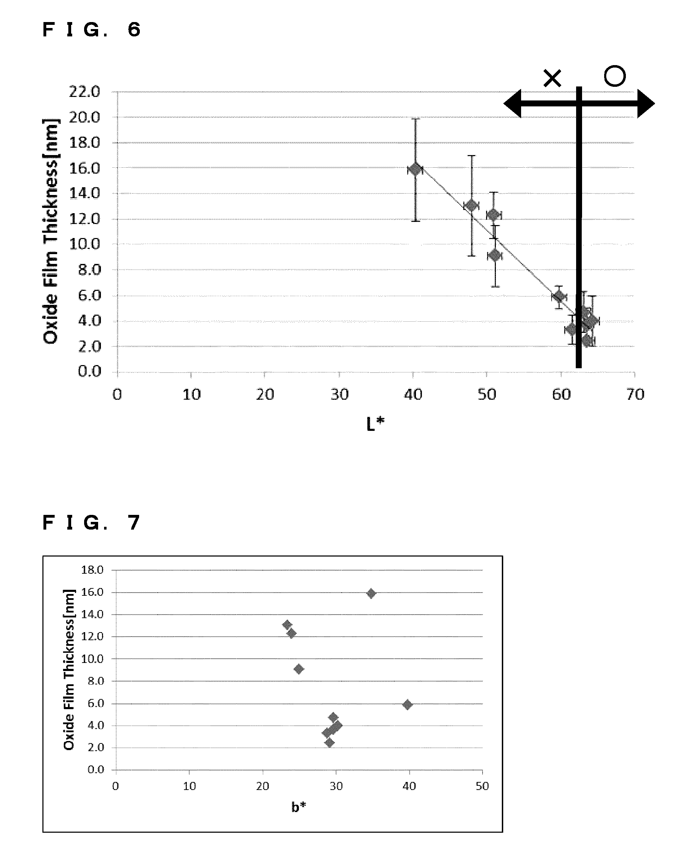

FIG.6 is a graph showing a relationship between L* value and oxide film thickness. As shown in FIG. 6, when L* value was 55 or more, the oxide film thickness was 8 nm or less, which indicated an excellent alignment performance as circular mark. However, when L* value was less than 55, the oxide film thickness exceeded 8 nm, which indicated a poor alignment performance as cross mark.

As a reference, it was examined whether or not degrees of the oxidation of the Cu ball could be determined by yellowness. FIG.7 is a graph showing a relationship between b* value and oxide film thickness. Differing from Sn-Ag-Cu based solder ball, a correlation of oxide film thickness was not shown by the yellowness. Therefore, it was made clear that the Cu ball could not be determined by yellowness.

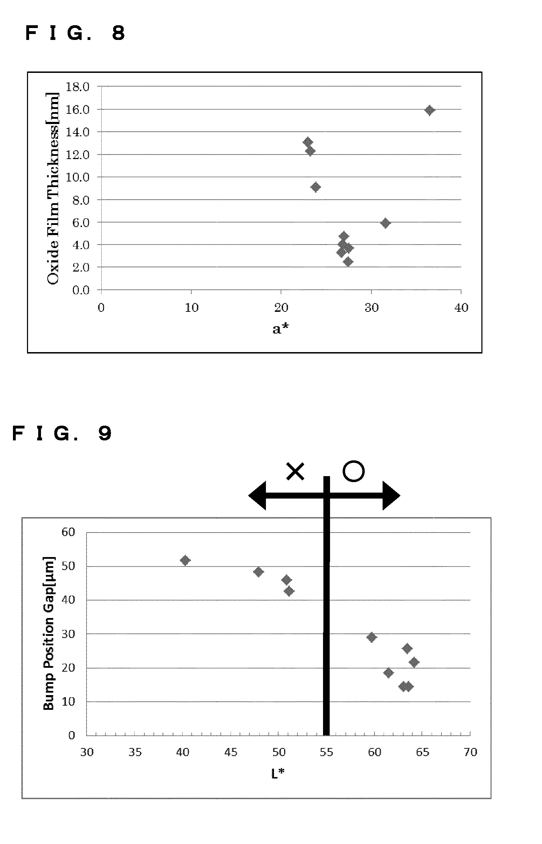

Further, it was examined whether or not degrees of the oxidation of the Cu ball could be determined by redness. FIG.8 is a graph showing a relationship between a* value and oxide film thickness of Cu ball. As a result thereof, a correlation of oxide film thickness was not shown by the redness. Therefore, it was made clear that the Cu ball could not be determined by redness.

Based on the result of Table 6, a relationship between L* value and average movement from mounting center position of the mounted Cu balls was illustrated. FIG.9 is a graph showing a relationship between L* value and average movement from mounting center position of the Cu balls when the Cu balls are mounted on the electrodes. It was shown that when the L* value is more increased, the average movement from mounting center position of the Cu balls was made smaller. Accordingly, it became clear that there was a correlation between L* value and movement from mounting center position of the Cu balls when the Cu balls are mounted on the electrodes. Further, as shown in FIG. 9, when the L* value was 55 or more, it became clear that the average movement from mounting center position was at least 30 µm or less.

As shown in FIGS. 3 and 9, it became clear that the Cu ball according to the invention allowed degree of oxidation of the Cu ball to be determined by the L* value.

## Claims

1. A Cu ball **characterized in that** the ball contains a purity of 99.995% or less and lightness of 55 or more.

2. The Cu ball according to Claim 1 further containing oxide film thickness of 8 nm or less on its surface.

3. The Cu ball according to Claim 1 or 2 further containing sphericity of 0.95 or more.

4. The Cu ball according to any one of Claims. 1 through 3 wherein the Cu ball contains a diameter of 1 through 1000 µm.

5. A solder joint using the Cu ball according to any one of the above-mentioned Claims. 1 through 4.
